# EUROPEAN PATENT SPECIFICATION

(11) **EP 0 466 121 B1**
(45) Date of publication and mention of the grant of the patent: **02.05.1997**
(21) Application number: 91111440.3
(22) Date of filing: 09.07.1991
(51) Int. Cl.: G03F 7/20

(54) **Carrier device**
Tragevorrichtung
Dispositif de transport

(30) Priority: 13.07.1990 JP 185777/90
(43) Date of publication of application: 15.01.1992
(73) Proprietor: Ono Sokki CO., LTD., Shinjiku-ku Tokyo 163 (JP)
(72) Inventor: Toyoda, Sei-ichiro, c/o Ono Sokki Co., Ltd., Yokohama-shi, Kanagawa-ken, 226 (JP); Funyu, Sadao, c/o Ono Sokki Co., Ltd., Utsunomiya, Utsunomiya-shi, Tochigi-ken, 321-01 (JP); Kashiwazaki, Tetsuo, c/o Ono Sokki Co., Ltd, Utsunomiya-shi, Tochigi-ken, 321-01 (JP); Fujita, Kazuo, c/o Ono Sokki Co., Ltd., Tech., Yokohama-shi, Kanagawa-ken, 226 (JP); Sasage, Kazunori, c/o Ono Sokki Co., Ltd., Yokohama-shi, Kanagawa-ken, 226 (JP); Yamamoto, Teijiro, c/o Ono Sokki Co., Ltd., Yokohama-shi, Kanagawa-ken, 226 (JP)
(74) Representative: Prechtel, Jörg, Dipl.-Phys. Dr.

(56) References cited:
- EP-A- 0 225 457
- DE-C- 4 013 127
- US-A- 4 951 089
- PATENT ABSTRACTS OF JAPAN vol. 14, no. 97 (M-940) 22 February 1990 & JP-A-1 306 245

## Description

This invention relates to a carrier device for carrying a work piece between a registration portion and a processing portion, and more particularly to a carrier device capable of both carrying the work piece into the processing portion (e.g., contact exposure portion) where an airtight chamber is formed and processing the work piece under the airtight condition.

It has been conventionally known as a method for transferring a circuit pattern to a printed board that an original form film forming the corresponding light-transmitted or flare pattern to the circuit pattern is exposed by overlapping on the printed board. In this case, for the purpose of obtaining a sufficient resolution, it was required to be exposed with a parallel light or to bring the original form film into contact with the printed board.

In addition, for the purpose of automatically positioning the original form film and the printed board, a method for taking the registration for both of them (See Japanese Patent Laid-open No. 61-281583). This method is processed by placing the registration portion for positioning and a registration table at a different position to carry the original form film positioned at the registration portion to the registration table and then, likewise, by carrying the printed board positioned at the registration portion to the registration table.

As, in case of the above-mentioned proposal, the printed board positioned at the registration portion was carried by suspending it with an adsorption arm, there was a possibility for producing a misregistration when adsorbed with the adsorption arm.

In addition, in case of transferring the registration table of the registration portion to the registration position as it is, the rate of carrying becomes delayed, and the position of the subsequent printed board cannot be determined while exposed, resulting in proposing the problem that the working efficiency is bad.

The object of the present invention is to provide a carrier device for enabling to resolve the preceding problem, accurately position, take the registration of the subsequent work piece while processed, and at the same time process in an airtight chamber.

A carrier device of the present invention, in which a sliding suction plate aspirating and holding a work piece moves between a registration portion for positioning the work piece on a registration table and a processing portion for processing the work piece on the processing table placed in an airtight chamber while keeping airtightness and becomes at least a part of the processing table, is characterized by installing a seal portion for sealing the gap between the remaining portion of the processing table and the sliding suction plate when the sliding suction plate moves to the processing portion.

On the basis of the present invention, when the sliding suction plate becomes a part of the processing table, the processing operation of exposure or the like can be done under the condition that the airtight chamber is formed by the seal portion. Namely, when the sliding suction plate becomes a part of the processing table, the gap between them has been sealed. As a result, the airtight operation at the processing portion has become possible. Therefore, the present invention has made it possible to move only the sliding suction plate and to carry the work piece between the registration portion and the processing portion at a high speed.

The foregoing and other objects and features of the invention will become apparent from the following description of preferred embodiments of the invention with reference to the accompanying drawings, in which:
Fig. 1A is a perspective view showing a carrier device as a first preferred embodiment of the present invention;
Fig. 1B is a perspective view showing the extracted carrier portion of the first preferred embodiment of the present invention;
Fig. 1C is an enlarged perspective view showing the extracted carrier portion of the first preferred embodiment;
Fig. 1D is a sectional view showing the extracted carrier portion of the first preferred embodiment;
Fig. 2A is a sectional view mainly showing a seal portion of the first preferred embodiment of the present invention;
Fig. 2B is a perspective view mainly showing the seal portion of the first preferred embodiment of the present invention;
Fig. 3A is a sectional view showing a carrier device as a second preferred embodiment of the present invention;
Fig. 3B is a sectional view showing the sealed condition of the second preferred embodiment of the present invention;
Fig. 4A is a sectional view showing a carrier device as a third preferred embodiment of the present invention;
Fig. 4B is an enlarged view showing a portion IVB of Fig. 4A;
Fig. 5A is a sectional view showing a carrier device as a fourth preferred embodiment of the present invention;
Fig. 5B is an enlarged view showing a portion VB of Fig. 5A;
Fig. 6A is a sectional view showing a carrier device as a fifth preferred embodiment of the present invention;
Fig. 6B is an enlarged view showing a portion VIB of Fig. 6A;
Fig. 7 is a sectional view showing a carrier device as a sixth preferred embodiment of the present invention;
Fig. 8 is a sectional view showing a carrier device as a seventh preferred embodiment of the present invention;
Fig. 9 is a sectional view showing a carrier device as an eighth preferred embodiment of the present invention;
Fig. 10A is a plan view showing a carrier device as a ninth preferred embodiment of the present invention;
Fig. 10B is a plan view mainly showing a processing portion of the ninth preferred embodiment of the present invention; and
Fig. 10C is a sectional view taken along line XC-XC of Fig. 10B.

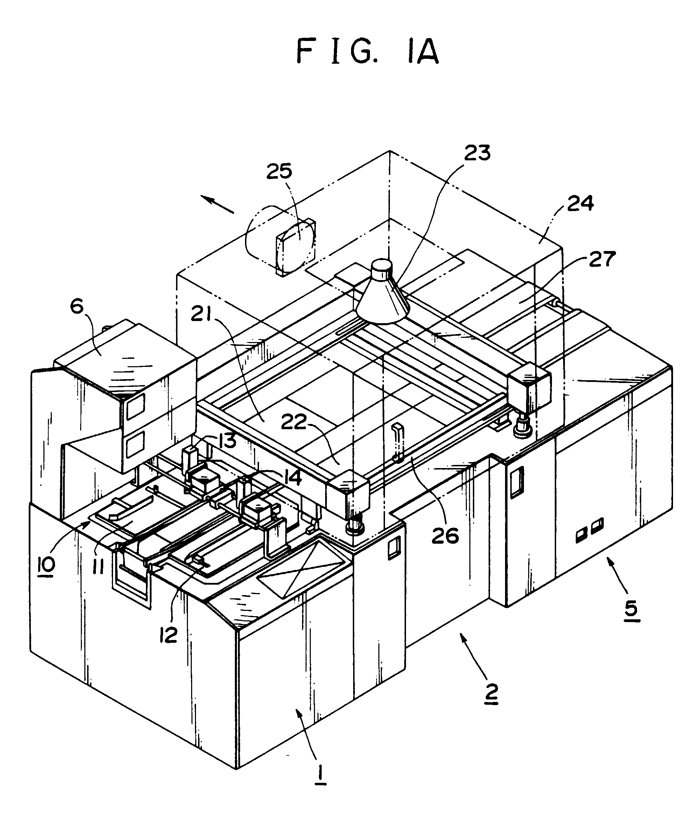

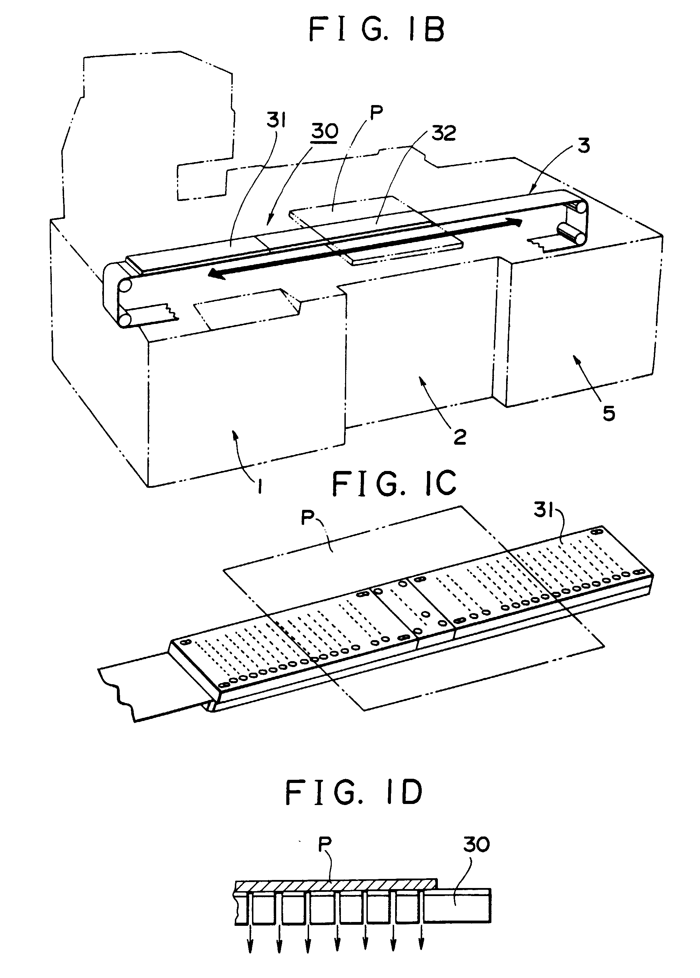

The detailed description will be given along the preferred embodiment incorporated with a carrier device of the present invention in an exposure device as shown in Fig. 1A. This exposure device comprises a registration portion 1, an exposure portion 2, a carrier portion 3, a seal portion 4, a release portion 5 and a control portion 6.

The registration portion 1 is placed on a registration table 10 at a proper interval in the direction perpendicular to the flow direction (the disposition direction of the registration portion 1, the exposure portion 2, and the release portion 5) of a printed board P whose first and second fixed suction plates 11, 12 are work pieces.

In the registration portion 1, a registration mark set on the printed board P is read out by CCD cameras 13, 14 placed at the upper side of the registration table 10, and an image processing is carried out by an image processing unit in the control portion 6 on the basis of the read-out image of the registration mark to generate a registration signal. A high speed and high accurate alignment can be made by moving the printed board P independently in X direction (the proceeding direction of the printed board P), Y direction (the direction perpendicular to the X direction within a horizontal plain) or θ direction (the rotational direction taking a table center as an axis) due to each table of X-, Y- or θ- axis incorporated in the registration table 10, on the basis of the generated signal.

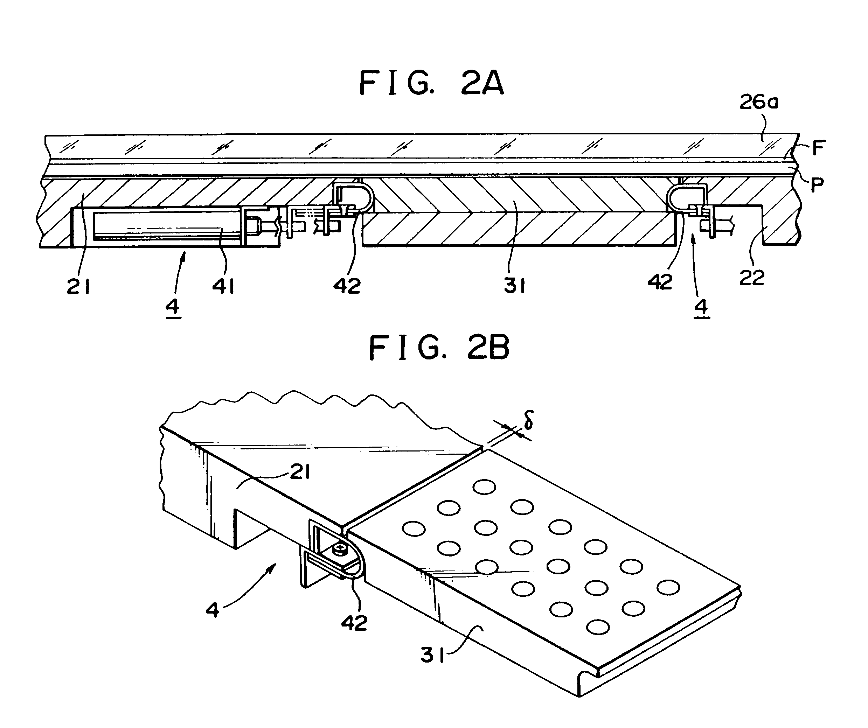

In the exposure portion 2, third and fourth fixed suction plates 21, 22 are placed at the similar intervals and in the similar directions to those of the first and second fixed suction plates 11 and 12, respectively. The exposure portion 2 as a processing portion is the portion exposed by means of an exposure lamp 23 by bringing an original form film F into contact with the printed board P as shown in Fig. 2A. This exposure portion 2 is covered with an exposure box 24. Cooled air is fed into the exposure box 24 from the bottom and the heat stream forwarded upwards by convention is exhausted to the outside of the exposure box 24 by a cooling fan 25. Therefore, a transparent support plate 26a composed of acrylic plate on an exposure table 26 and the original form film F are prevented from thermally expanding. The exposure table 26 moves upwards or downwards and enables to put the original form film F glued on the transparent support plate 26a over the printed board P carried.

In the carrier portion 3, a carrier table 30 is inserted into the wide channel installed between the first and second fixed suction plates 11, 12 and between the third and fourth fixed suction plates 21, 22. The carrier table 30 is composed of a sliding suction plate 31 for carrying in and a sliding suction plate 32 for carrying out. Fig. 1B shows the condition that the sliding suction plate 31 locates at the registration portion 1 and the other one 32 locates at the exposure portion 2.

The seal portion 4 is available for sealing the gap between the fixed suction plates 21, 22 of the exposure portion 2 and the sliding suction plates 31, 32 of the carrier portion 3. This seal portion 4 is installed to the lower side of the fixed suction plates 21, 22 and has a structure that a belt-like packing 42 with the corresponding length to that of the gap is installed to the rod of an air cylinder 41, as shown in Fig. 2. When the rod of the air cylinder 41 expands, the packing 42 is set to seal the gap between the fixed suction plate 21 and the sliding suction plate 32.

The release portion 5 is a portion for carrying the printed board P exposed at the exposure portion 2 to the next process. This can be either a stock portion depending on the production line or a reverse portion in case the back face of the printed board P is exposed.

Now, the operation for the carrier device of the present invention is described using an example in case of the exposure device.

In the carrier portion 3, the sliding suction plate 31 locates at the registration portion 1 and the other one 32 locates at the exposure portion 2 as shown in Fig. 1B. At this portion, the original form film F is positioned under the condition aspirated by the fixed suction plates 11, 12 in the registration portion 1. At this time, a pressure sensitive adhesive double coated tape is attached on the upper surface of the original form film F.

The sliding suction plate 31 is carried to the exposure portion 2 under the condition that the original form film F is aspirated. At this position, the exposure table 26 is lowered and the original form film F is attached on the transparent support plate 26a of the exposure table 26 by the pressure sensitive adhesive double coated tape. After then, the original form film F is firmly fixed by means of a fixed tape by raising the exposure table 26 and lifting it up at the front. Furthermore, instead of the adhesion by these tapes, a suction channel may be installed to the opposite surface of the transparent support plate 26a to make the original form film F sucked. The above-mentioned positioning of the original form film F and the gluing of it on the exposure table 26 are an operation at the preparatory stage to be carried out in advance of the exposure to a board and are done at one time only independently of the exposure process to the following board.

Subsequently, the sliding suction plate 31 returns to the registration portion 1 and aspirates the unexposed printed board P to carry it to the exposure portion 2.

After then, the exposure table 26 is lowered and the original form film F is put on the printed board P aspirated by the sliding suction plate 31. At this position, the original form film F glued on the exposure table 26 and the printed board P are accurately positioned.

At this time, the rod of the air cylinder 41 in the seal portion 41 expands and the gap between fixed suction plates 21, 22 and the sliding suction plate 31 is plugged with the packing 42 to form an airtight chamber between the exposure table 26 and the seal portion. In this condition, the original form film F is brought into contact with the printed board P (refer to the condition of Fig. 2A) by aspirating with the fixed suction plates 21, 22 and the sliding suction plate 31, and the exposure is done by the exposure lamp 23.

After the exposure, the sliding suction plate 31 of the carrier portion 3 returns to the registration portion 1, and the printed board P already positioned is carried to the exposure portion 2. At the same time, the sliding suction plate 32 of the carrier portion 3 carries the printed board P exposed at the exposure portion 2 to the release portion 5. Subsequently, this operation is repeated.

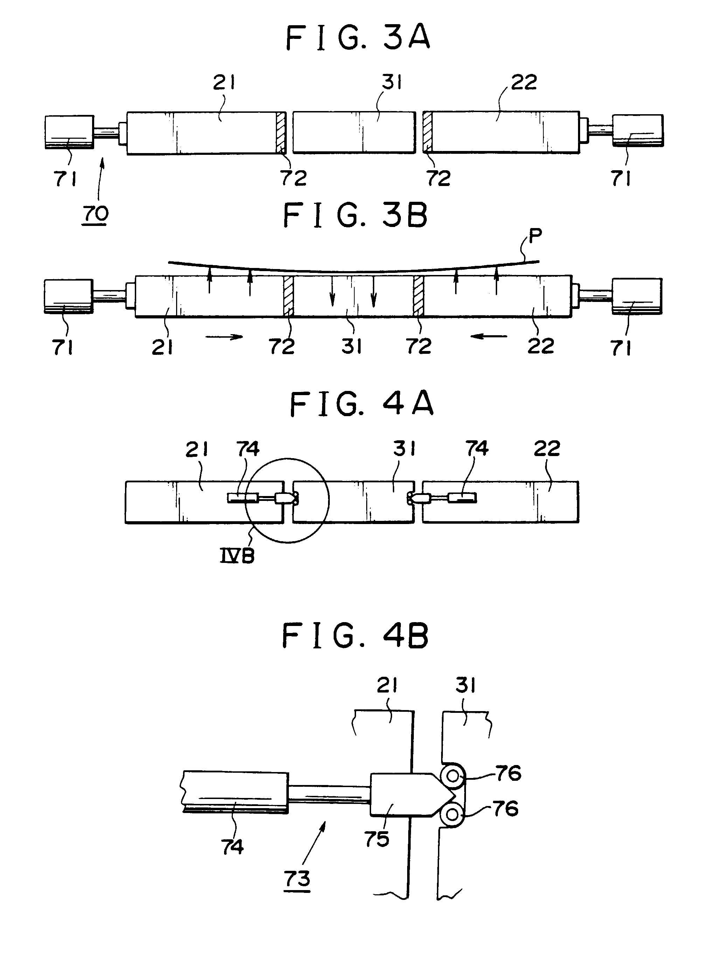

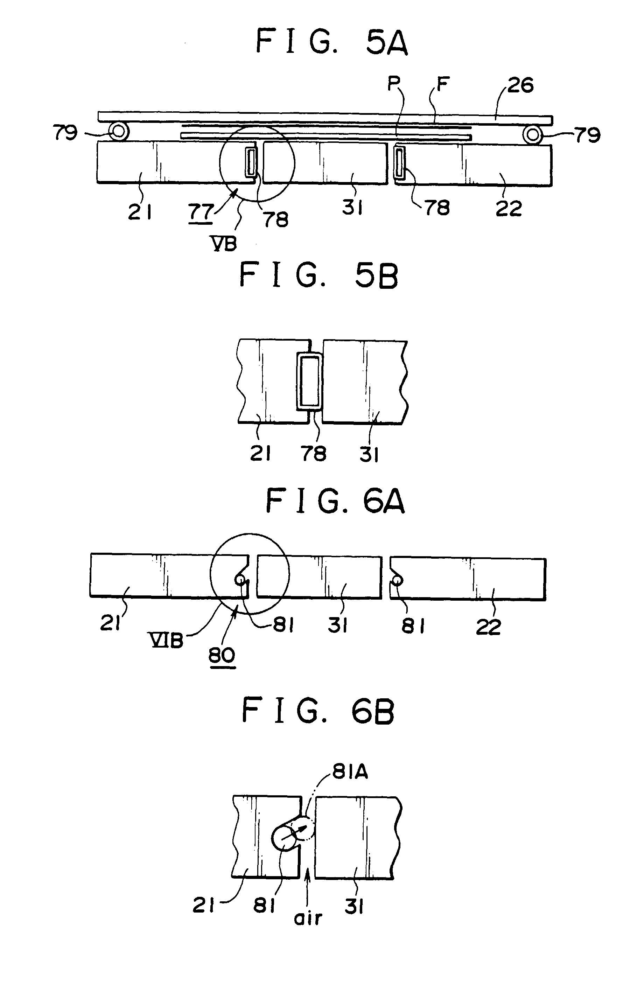

Referring now to Figs. 3 to 9, an alternative preferred embodiment of the carrier device of the present invention is described. Furthermore, at this time, the structure of the seal portion is mainly explained and in the other portion, the portions having the similar functions to those in the preceding preferred embodiment are attached with their identical symbols and numerals.

In a seal portion 70 of a second preferred embodiment, packings 72 are installed to the end surfaces of the fixed suction plates 21, 22 to seal the gaps by pushing the fixed suction plates 21, 22 against the sliding suction plate 31 by means of an air cylinder 71. At this time, at the moment when the fixed suction plates 21, 22 are moved, both sides of the printed board P and the original form film F are lifted using the exhaust air from the air cylinder 71 and can be prevented from being loosened, as shown in Fig. 3B.

In a seal portion 73 of a third preferred embodiment, concave portions are installed to the end surfaces of the sliding suction plate 31, into which rod-like packings are inserted, and the gaps are sealed by a shutter 75 of the rod in the air cylinders 74 installed to the sides of the fixed suction plates 21, 22.

In a seal portion 77 of a fourth preferred embodiment, tube-like packings 78 are installed to the end portions of the fixed suction plate 21, 22, and the gaps are sealed by the transformation of the packings due to air feed in or air release from the packings. The air feed and the air release may be co-operated each other by inserting the tube-like packings 79 between the fixed suction plates 21, 22 and the transparent support plate 26a.

In a seal portion 80 of a fifth preferred embodiment, channels are installed obliquely downwards to the end portions of the fixed suction plates 21, 22 and inserted with rod-like packings 81. When aspirating for bringing into contact each other, air flows in an arrow direction from the gaps between the fixed suction plates 21, 22 and the sliding suction plate 31. Therefore, by use of the resulting negative pressure, the gaps are sealed by lifting the packings 81.

In a seal portion 82 of a sixth preferred embodiment, the gaps between the fixed suction plates 21, 22 and the sliding suction plate 31 are sealed by expanding and shrinking the rods of the air cylinder 83 installed to the bottoms of the gaps and raising and dropping the packings 84 installed on the top ends of the rods.

In a seal portion 85 of a seventh preferred embodiment, the gaps between the fixed suction plates 21, 22 and the sliding suction plate 31 are sealed by expanding and shrinking the rods of the air cylinders 86 and moving the packings 87 installed to the top ends of the rods forward and backward.

In a seal portion 88 of an eighth preferred embodiment, the end portions of the fixed suction plates 21, 22 and the sliding suction plate 31 are set in a tapered form and glued with packings 89, 90, and the gaps are sealed by the motion for varying the upper and lower positions of the fixed suction plates 21, 22 when the sliding suction plate 31 moves.

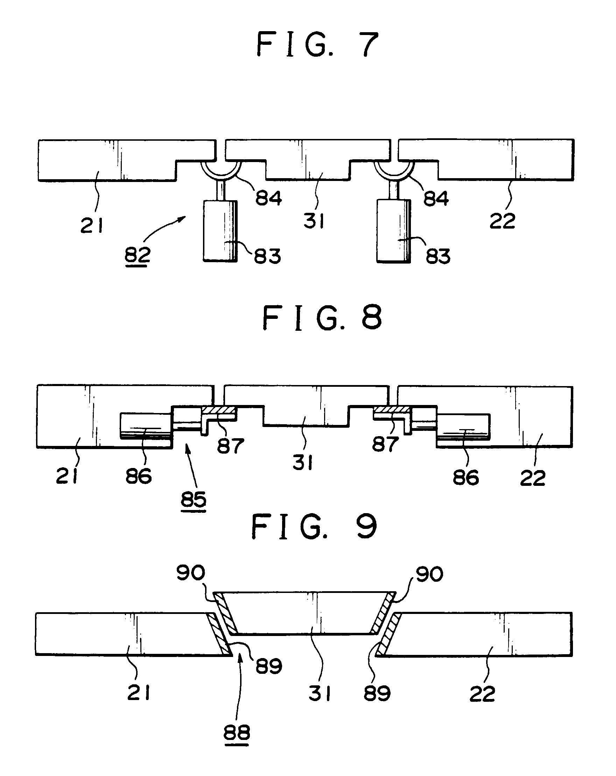

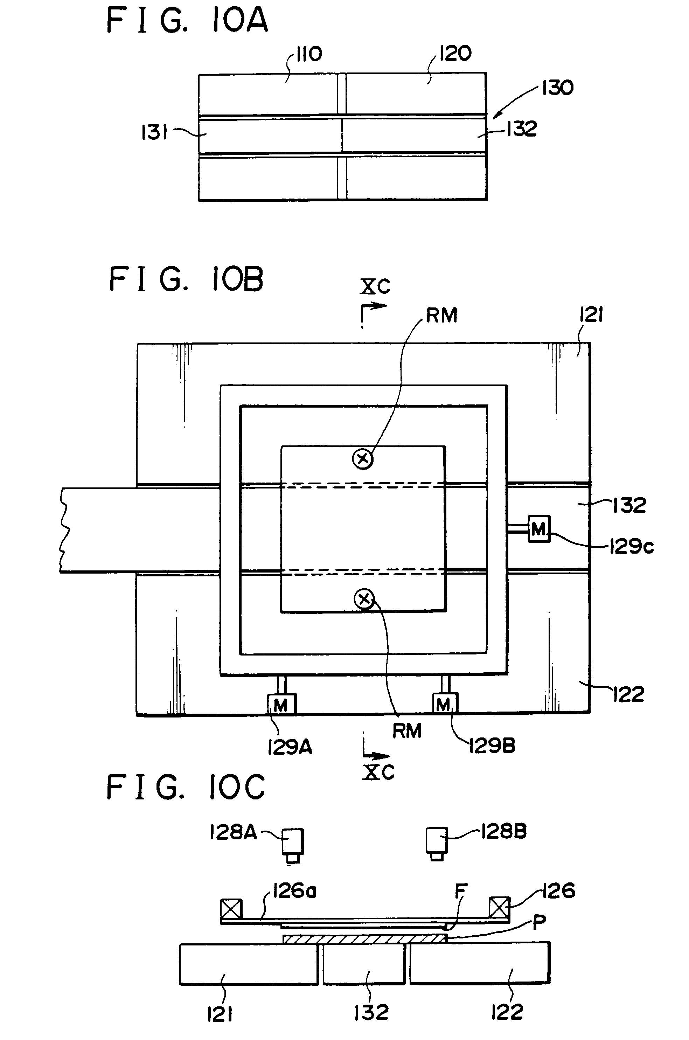

Fig. 10A is a plan view showing a carrier device as a ninth preferred embodiment of the present invention. Fig. 10B is a plan view mainly showing the processing portion of the ninth preferred embodiment of the present invention of Fig. 9. Fig. 10C is a sectional view taken along line XC-XC of Fig. 10B.

The carrier device of the ninth preferred embodiment of the present invention comprises a registration portion 110, an exposure portion 120 and a carrier portion 130.

In the registration portion 110, the rough positioning of the printed board P aspirated on the sliding suction plate 132 is only done by pushers, stoppers or the like. In a transparent support plate 126a supported by a frame body 126 in the exposure portion 120, the original form film F is glued on a required position and this frame body 126 can be accurately driven by pulse motors 129A, 129B in the direction of θ and by another pulse motor 129C in the direction of X, respectively.

At the upper side of the frame body 126, monitor cameras 128A, 128B (e.g. CCD camera) are arranged and read out the registration mark RM placed at the relative position of the printed board P and the original form film F carried by the sliding suction plate 31 in the exposure portion 120. The pulse motors 129A, 129B, 129C move the frame body 126 following the position signals detected by the monitor cameras 128A, 128B and take the accurate registration of the printed board P and the original form film F.

The seal portions as herein disclosed from the first to eighth preferred embodiments of the present invention can be also applied to such a carrier device.

Although an exposure device was described as an example, other devices may be used in case the corresponding operation requires airtightness in the processing portion and furthermore it may be used in case the airtight chamber is not only reduced in pressure but also compressed. It is possible to install the seal portion disclosed in each preferred embodiment attached with the sides of the fixed suction plates and the sliding suction plate to the side of the sliding suction plate or the fixed suction plate so far as it does not prevent the motion of each portion. For example, the packings 72 may be installed to the side of the sliding suction plate 31.

In the preferred embodiment described in Figs. 1A, the example installed to the registration portion 1, the exposure 2 and the release portion 5 was disclosed, but the carrier device of the present invention can be applied to the apparatus without the release portion 5. For example, the printer disclosed in Japanese Patent Laid-open No. 1-306245 has the following structure given by separating its printing machine from its registration machine, forming channels in a part of these plain registration table and printing table, forming at least the fixed suction plate in the remaining portion of the printing table, passing a guide rail between both of the channels, supporting movably the sliding suction plate on the guide rail, connecting the sliding suction plate to a reversible moving source to freely reciprocate in the required stroke part corresponded to the distance between both of the tables, freely switching the upper surface of the sliding suction plate and that of both tables in part at three stages of the same plain, protrusion and pit, and connecting the sliding suction plate to a part of an endless belt, while the sliding suction plate is formed so that the length of the sliding suction plate in its travelling direction may be roughtly same as that of the table for printing and the width may be slightly smaller than that of the channel. Therefore, the release of a printed matter is done by a release belt passing through the channel, and the release portion becomes useless. Even the case where the carrier portion of such a printer is applied to the exposure device of the first preferred embodiment as it is, and the structure installing the seal portion between the sliding suction plate and the fixed suction plate is within the present invention.

Although in the preferred embodiment shown in Fig. 10C, the monitor cameras 128A, 128B were explained as an example placed at the upper side of the frame body 126, they may be placed at the lower side thereof. In this case, a portion or all of the table (121, 122 or the like) may be transparent body.

## Claims

1. A carrier device, which becomes a part of at least a processing table by moving sliding suction plates (31,32) for aspirating and holding a work piece between a registration portion (1) for positioning the work piece on a registration table and a processing portion (2) for processing said work piece while keeping airtightness on the processing table arranged said work piece within an airtight chamber, characterized by providing a seal portion (4) for sealing the gap between the remaining portions (21,22) of said processing table and said sliding suction plates when said sliding suction plates (31,32) move to said processing portion (2).

2. A carrier device according to claim 1, wherein an accommodation portion is formed on the surface of said sliding suction plate (31) and/or that of the remaining portions (21, 22) of said processing table, and said seal portion (4) is composed of a flexible membrane (42) placed in said accommodation portion and having air tightness and a belt-like form enough long to cover said gap, and drive means (41) for pushing said flexible membrane against the inner wall of each accommodation portion.

3. A carrier device according to claim 1, wherein said seal portion (70) is composed of a seal material (72) installed to the end surface of said sliding suction plate (31) and/or that of the remaining portions (21, 22) of said processing table, and drive means (71) for pushing said processing table against the side of said sliding suction plate.

4. A carrier device according to claim 1, wherein said seal portion (73) is composed of a seal material (76) installed to the end surface of said sliding suction plate (31) and/or that of the remaining portions (21, 22) of said processing table, a shutter member (75) contacting with said seal material in airtightness, and drive means (74) for driving to push said shutter member against said seal material.

5. A carrier device according to claim 1, wherein said seal portion (77) is composed of a tube-like seal material (78) to be inserted into said gap, and an air source for feeding air to the internal space of said seal material.

6. A carrier device according to claim 1, wherein a concave portion inclined to the side of said airtight chamber is formed on the end surface of said sliding suction plate (31) or that of the remaining portions (21, 22) of said processing table, and said seal portion (80) is composed of an elongate rod member (81) accommodated in said concave portion, said rod member being aspirated out and pushed against said end surface when the pressure of said airtight chamber becomes negative.

7. A carrier device according to claim 1, wherein said seal portions (82, 85) are composed of a seal materials (84, 87) for sealing said gap, and drive means (83, 86) for driving so as to push said seal material by moving in parallel or perpendicular to said gap.

8. A carrier device according to claim 1, wherein the end surface of said sliding suction plate (31) and that of the remaining portions (21, 22) of said processing table are inclined respectively, said seal portion (88) is composed of seal materials (89, 90) installed to both or either of said end surfaces, and drive means moving said sliding suction plate in the direction perpendicular to the plate surface.

## Patentansprüche

1. Trägervorrichtung, welche zu einem Teil von wenigstens einem Bearbeitungstisch wird, indem Verschiebeansaugplatten (31, 32) zum Ansaugen und Halten eines Werkstücks zwischen einem Justierabschnitt (1) zum Positionieren des Werkstücks auf einem Justiertisch und einem Bearbeitungsabschnitt (2) zum Bearbeiten des Werkstücks bewegt werden, während am Bearbeitungstisch eine Luftdichtigkeit beibehalten ist und das Werkstück innerhalb einer luftdichten Kammer angeordnet ist, gekennzeichnet durch das Vorsehen eines Dichtungsabschnitts (4) zum Abdichten des Zwischenraums zwischen den verbleibenden Abschnitten (21, 22) des Bearbeitungstisches und den Verschiebeansaugplatten, wenn die Verschiebeansaugplatten (31, 32) sich zu dem Bearbeitungsabschnitt (2) bewegen.

2. Trägervorrichtung nach Anspruch 1, worin ein Aufnahmeabschnitt an der Oberfläche der Verschiebeansaugplatte (31) und/oder denjenigen der verbleibenden Abschnitte (21, 22) des Bearbeitungstisches ausgebildet ist, und worin der Dichtungsabschnitt (4) eine flexible Membran (42) umfaßt, die in dem Aufnahmeabschnitt angeordnet ist und eine Luftdichtigkeit und eine bandartige Form aufweist, die lang genug ist, um den Zwischenraum abzudichten, sowie Antriebsmittel (41) zum Drücken der flexiblen Membran gegen die Innenwand jedes Aufnahmeabschnitts.

3. Trägervorrichtung nach Anspruch 1, worin der Dichtungsabschnitt (70) ein Dichtungsmaterial (72) umfaßt, das an der Stirnfläche der Verschiebeansaugplatte (31) und/oder denjenigen der verbleibenden Abschnitte (21, 22) des Bearbeitungstisches angebracht ist, sowie Antriebsmittel (71) zum Drücken des Bearbeitungstisches gegen die Seite der Verschiebeansaugplatte.

4. Trägervorrichtung nach Anspruch 1, worin der Dichtungsabschnitt (73) ein Dichtungsmaterial (76) umfaßt, daß an der Stirnfläche der Verschiebeansaugplatte (31) und/oder denjenigen der verbleibenden Abschnitte (21, 22) des Bearbeitungstisches angebracht ist, und ein Verschlußelement (75), welches das Dichtungsmaterial luftdicht berührt, und Antriebsmittel (74) zum Antreiben, um das Verschlußelement gegen das Dichtungsmaterial zu drücken.

5. Trägervorrichtung nach Anspruch 1, worin der Dichtungsabschnitt (77) ein röhrenartiges Dichtungsmaterial (78), das in den Zwischenraum einzuführen ist, und eine Luftquelle zum Zuführen von Luft zu dem Innenraum des Dichtungsmaterials umfaßt.

6. Trägervorrichtung nach Anspruch 1, worin ein zu der Seite der luftdichten Kammer geneigter konkaver Abschnitt an der Stirnfläche der Verschiebeansaugplatte (31) oder denjenigen der verbleibenden Abschnitte (21, 22) des Bearbeitungstisches ausgebildet ist, und worin der Dichtungsabschnitt (80) ein langgestrecktes Stabelement (81) umfaßt, das in dem konkaven Abschnitt aufgenommen ist, wobei das Stabelement dann, wenn in der luftdichten Kammer ein Unterdruck erzeugt wird, herausgesaugt wird und gegen die Stirnfläche gedrückt wird.

7. Trägervorrichtung nach Anspruch 1, worin die Dichtungsabschnitte (82, 85) Dichtungsmaterialien (84, 87) zum Abdichten des Zwischenraums umfassen sowie Antriebsmittel (83, 86) zum Antreiben, um das Dichtungsmaterial durch Bewegung parallel oder orthogonal zu dem Zwischenraum zu drücken.

8. Trägervorrichtung nach Anspruch 1, worin die Stirnfläche der Verschiebeansaugplatte (31) und diejenigen der verbleibenden Abschnitte (21, 22) des Bearbeitungstisches jeweils geneigt sind, wobei der Dichtungsabschnitt (88) Dichtungsmaterialien (89, 90) umfaßt, die an beiden oder einer der Stirnflächen angebracht sind, und Antriebsmittel, welche die Verschiebeansaugplatte in der Richtung orthogonal zu der Plattenoberfläche bewegen.

## Revendications

1. Dispositif de transport qui devient partie d'au moins une table de traitement en déplaçant des plaques d'aspiration coulissantes (31,32) destinées à aspirer et maintenir une pièce à travailler entre une partie de repérage (1) pour positionner la pièce à travailler sur une table de repérage et une partie de traitement (2) pour traiter ladite pièce à travailler tout en maintenant une étanchéité à l'air sur ladite pièce à travailler, placée sur la table de traitement à l'intérieur d'une chambre étanche à l'air, caractérisé par une partie d'étanchéité (4) destinée à fermer hermétiquement le vide entre les parties restantes (21,22) de ladite table de traitement et lesdites plaques d'aspiration coulissantes lorsque lesdites plaques d'aspiration coulissantes (31,32) se déplacent vers ladite partie de traitement (2).

2. Dispositif de transport selon la revendication 1, dans lequel une partie de placement est formée sur la surface de ladite plaque d'aspiration coulissante (31) et/ou sur celle des parties restantes (21,22) de ladite table de traitement, et ladite partie d'étanchéité (4) est composée d'une membrane souple (42), placée dans ladite partie de placement et présentant une étanchéité à l'air et une forme de type bande suffisamment longue pour couvrir ledit vide, et de moyens d'entraînement (41) pour pousser ladite membrane souple contre la paroi interne de chaque partie de placement.

3. Dispositif de transport selon la revendication 1, dans lequel ladite partie d'étanchéité (70) est composée d'un matériau d'étanchéité (72), placé sur la surface d'extrémité de ladite plaque d'aspiration coulissante (31) et/ou sur celle des parties restantes (21,22) de ladite table de traitement, et de moyens d'entraînement (71) pour pousser ladite table de traitement contre le côté de ladite plaque d'aspiration coulissante.

4. Dispositif de transport selon la revendication 1, dans lequel ladite partie d'étanchéité (73) est composée d'un matériau d'étanchéité (76) placé sur la surface d'extrémité de ladite plaque d'aspiration coulissante (31) et/ou sur celle des parties restantes (21,22) de ladite table de traitement, d'un élément d'obturation (75) venant en contact avec ledit matériau d'étanchéité pour assurer l'étanchéité à l'air, et de moyens d'entraînement (74) pour entraîner, en le poussant, ledit élément d'obturation contre ledit matériau d'étanchéité.

5. Dispositif de transport selon la revendication 1, dans lequel ladite partie d'étanchéité (77) est composée d'un matériau d'étanchéité (78) en forme de tube à insérer dans ledit vide, et d'une source d'air pour envoyer de l'air dans l'espace interne dudit matériau d'étanchéité.

6. Dispositif de transport selon la revendication 1, dans lequel une partie concave inclinée du côté de ladite chambre étanche à l'air est formée sur la surface d'extrémité de ladite plaque d'aspiration coulissante (31) ou sur celle des parties restantes (21,22) de ladite table de traitement, et ladite partie d'étanchéité (80) est composée d'un élément allongé formant tige (81), logé dans ladite partie concave, ledit élément formant tige étant aspiré à l'extérieur et poussé contre ladite surface d'extrémité lorsque la pression de ladite chambre étanche à l'air devient négative.

7. Dispositif de transport selon la revendication 1, dans lequel lesdites parties d'étanchéité (82,85) sont composées de matériaux d'étanchéité (84,87) destinés à fermer hermétiquement ledit vide, et de moyens d'entraînement (83,86) pour entraîner, de manière à le pousser, ledit matériau d'étanchéité en le déplaçant dans un sens parallèle ou perpendiculaire audit vide.

8. Dispositif de transport selon la revendication 1, dans lequel la surface d'extrémité de ladite plaque d'aspiration coulissante (31) et celle des parties restantes (21,22) de ladite table de traitement sont respectivement inclinées, ladite partie d'étanchéité (88) est composée de matériaux d'étanchéité (89,90) placés sur les deux ou sur l'une desdites surfaces d'extrémité, et de moyens d'entraînement déplaçant ladite table d'aspiration coulissante dans le sens perpendiculaire à la surface de la plaque.
